# FASCICULE DE BREVET EUROPEEN

(11) **EP 3 050 097 B1**
(45) Date de publication et mention de la délivrance du brevet: **04.11.2020**
(21) Numéro de dépôt: 14789877.9
(22) Date de dépôt: 22.08.2014
(51) Int. Cl.: H01L 23/38, H01L 23/427

(54) **APPAREIL COMPORTANT UN COMPOSANT FONCTIONNEL SUSCEPTIBLE D'ETRE EN SURCHARGE THERMIQUE LORS DE SON FONCTIONNEMENT ET UN SUSTEME DE REFROIDISSEMENT DU COMPOSANT**
VORRICHTUNG MIT EINER FUNKTIONELLEN KOMPONENTE MIT WAHRSCHEINLICHER THERMISCHER ÜBERLASTUNG WÄHREND DES BETRIEBS DAVON UND SYSTEM ZUR KÜHLUNG DER KOMPONENTE
APPARATUS COMPRISING A FUNCTIONAL COMPONENT LIKELY TO BE THERMALLY OVERLOADED DURING THE OPERATION THEREOF AND A SYSTEM FOR COOLING THE COMPONENT

(30) Priorité: 23.09.2013 FR 1359095
(43) Date de publication de la demande: 03.08.2016
(73) Titulaire: Commissariat à l'Énergie Atomique et aux Énergies Alternatives, 75015 Paris (FR); Schneider Electric Industries S.A.S., 92500 Rueil-Malmaison (FR)
(72) Inventeur: CAROFF, Tristan, 38610 Gieres (FR); RADOSLAVA, Mitova, F-38240 Meylan (FR); SIMON, Julia, F-38100 Grenoble (FR)
(74) Mandataire: Nony
(86) Numéro de dépôt international: PCT/IB2014/064024
(87) Numéro de publication internationale: WO 2015/040514

(56) Documents cités:
- EP-A2- 1 162 659
- EP-A2- 1 331 838
- WO-A1-02/17471
- US-A- 5 596 228

## Description

### Domaine technique

La présente invention concerne un appareil comportant un composant fonctionnel susceptible d'être en surcharge thermique lors de son fonctionnement et un système de refroidissement du composant.

L'invention a trait à la réalisation d'un système de refroidissement amélioré qui permet d'absorber la surcharge thermique du composant tout en étant de dimensionnement limité.

Bien que décrite en référence à l'application de refroidissement de composants électroniques de puissance, l'invention peut tout aussi bien s'appliquer au refroidissement de tout composant fonctionnel susceptible d'être en surcharge thermique lors de son fonctionnement pendant des périodes jusqu'à quelques dizaines de minute. Ainsi, le composant fonctionnel peut être un calculateur, un micro-processeur, une plaque chauffante pour laquelle on cherche à absorber du dépassement de température lors d'une régulation thermique avec correcteur PID (pour « proportionnel intégral dérivé»).

On précise que dans le cadre de l'invention, on entend par « composant fonctionnel », un seul élément ou plusieurs éléments de composant associés entre eux pour réaliser une fonction donnée dans un appareil. Par exemple, il peut s'agir d'un ensemble de plusieurs éléments de composants électroniques de puissance assemblés sur un même substrat et associés entre eux.

On précise également qu'on entend par « surcharge thermique », un fonctionnement d'un composant fonctionnel pendant une période donnée à des températures élevées au point d'être préjudiciables à sa durée de vie voire nuire à son état de marche instantanément. Autrement dit, on entend des pics de puissance thermique subis par le composant fonctionnel pendant une période donnée et suffisamment importants pour être néfastes à l'état de marche dudit composant, ou à tout le moins réduire sa durée de vie. Typiquement, un composant électronique de puissance à base de silicium (Si), carbure de silicium (SiC) ou nitrure de gallium (GaN) est susceptible d'être en surcharge thermique lorsqu'il chauffe de quelques watts pendant une période de quelques minutes.

On précise également qu'on entend par « régime nominal », un fonctionnement d'un composant fonctionnel pendant une période donnée qui n'engendre pas de surcharge thermique de celui-ci.

On précise également qu'on entend par « module thermoélectrique » ou module TEC, un module qui parcouru par un courant électrique établit une différence de température. Il s'agit donc d'un module que l'on utilise en mode actif, aussi usuellement dénommé module Peltier qui met en œuvre l'effet Peltier.

On précise enfin qu'on entend par « dissipateur thermique » un dispositif dont la surface d'échange avec le milieu environnant permet de réaliser un refroidissement par convection d'au moins une partie de chaleur émise par le composant fonctionnel. Il peut donc s'agir d'un dissipateur thermique au sens usuel en électronique de puissance, i.e. un dispositif destiné à favoriser l'évacuation de la chaleur dissipée par des éléments semiconducteurs de puissance.

### Etat de la technique

Actuellement, d'importantes investigations sont menées pour intégrer les nouveaux composants électroniques de puissance à base de Si, SiC ou GaN dans différents types d'appareils.

Cependant, il est d'ores et déjà éprouvé que dans certains appareils électriques dans lesquels ils sont intégrés, ces composants de puissance sont susceptibles d'être soumis à des surcharges électriques de façon intermittente et donc à des surplus de puissance électrique et donc de chaleur à évacuer. Typiquement, des transistors bipolaires à grille isolée (*IGBT,* acronyme anglais de « *Insulated Gate Bipolar Transistor* ») peuvent être alimentés sous un courant de l'ordre de 110 % du courant nominal pendant des périodes relativement courtes de l'ordre de 1 à 5 min, ce qui est susceptible de dégrader leurs jonctions.

Aussi, en sus d'un système de refroidissement dimensionné pour le fonctionnement en régime nominal, il apparaît nécessaire de prévoir un système de refroidissement supplémentaire afin de limiter les températures auxquelles les composants sont soumis lors de ces surcharges, en particulier afin de limiter les températures des jonctions.

Usuellement, le système de refroidissement pour le fonctionnement en régime nominal est constitué par un dissipateur thermique munis d'ailettes, désigné ci-après dissipateur thermique nominal, qui est solidarisé à une face principale du substrat qui supporte les composants électroniques de puissance.

Pour constituer le système de refroidissement supplémentaire, i.e. celui dédié au refroidissement des pics de chaleur importants auxquels sont soumis les composants de puissance, on pourrait envisager différentes solutions existantes.

On pourrait tout d'abord penser à ajouter uniquement un dissipateur thermique à ailettes usuel, en le solidarisant à l'autre face principale du substrat. Or, le faire reviendrait à sur-dimensionner largement le système de refroidissement complet puisque le volume intrinsèque du dissipateur supplémentaire serait conséquent, typiquement égal à celui du dissipateur thermique nominal.

On pourrait également penser à ajouter uniquement un module thermoélectrique, en particulier un module Peltier, au dissipateur thermique nominal. Or, la face chaude d'un module thermoélectrique dégagerait une très grande quantité de chaleur en cas de pics de chaleur importants. L'efficacité d'un module thermoélectrique utilisé seul est donc limitée à des puissances thermiques à évacuer qui restent relativement faibles.

On pourrait enfin penser à ajouter uniquement une cellule contenant un matériau à changement de phase (MCP), au dissipateur thermique nominal. Or, cela n'est pas possible en cas de puissances thermiques à évacuer importantes car, dans ce cas la température de surchauffe atteinte par le composant devient largement supérieure à la température de fusion du matériau MCP car il n'a pas la capacité d'absorber rapidement la surcharge thermique.

Il est déjà connu de la littérature des systèmes de refroidissement de composant associant les éléments des différentes solutions précitées.

Ainsi, la demande de brevet EP 2505913A1 décrit un système de refroidissement d'une source de chaleur dans lequel la chaleur émise par la source est transférée à une cellule contenant un matériau à changement de phase (MCP) par l'intermédiaire d'un simple premier interrupteur thermique, tel qu'un microsystème électromécanique (MEMS). Dès que le matériau MCP subit un changement de phase, le premier interrupteur est ouvert et l'actionnement d'un deuxième interrupteur thermique, qui peut être un module Peltier, permet la dissipation de chaleur stockée par le matériau MCP, en particulier par l'intermédiaire d'un dissipateur thermique conventionnel. Un tel système n'est pas adapté pour absorber des pics de puissance thermique de la source car le premier interrupteur thermique ne fait que conduire la chaleur dégagée par la source au matériau MCP pour atteindre son changement de phase. Autrement dit, il ne peut y avoir réellement de pompage de pics de puissance thermique qui se produiraient sur la source et le matériau MCP, celui-ci n'étant d'ailleurs réellement dimensionné que pour garantir une température homogène de la source avant son fonctionnement nominal.

La demande de brevet US 2006/0088271 décrit un système de refroidissement d'un composant électronique ou optoélectronique dans lequel, au préalable de la mise en fonctionnement du composant, un module TEC est déclenché pour transférer la chaleur de la base du composant à un matériau MCP encapsulé dans un encapsulant isolant thermique. Ici encore, en cas de surcharge thermique du composant, il ne peut y avoir d'absorption de celle-ci, le matériau MCP n'étant dimensionné que pour garantir une température homogène de la source avant son fonctionnement nominal.

Le brevet US 8087254 décrit un système de refroidissement de la chaleur émise par la tête d'une personne, intégré à un casque, dans lequel un caloduc permet d'évacuer la chaleur dans une zone éloignée, la chaleur ainsi évacuée étant transférée au moyen de modules thermoélectriques soit dans un dissipateur thermique soit dans un matériau MCP. Ici, il ne peut y avoir de stockage à proprement parler de la chaleur et le système décrit ne peut absorber des pics de puissance thermique. Les brevets EP1331838A2 et WO02/17471A1 décrivent la mise en oeuvre d'un module thermoélectrique pour la production de l'électricité.

Il existe donc un besoin pour améliorer le système de refroidissement d'un composant fonctionnel susceptible d'être en surcharge thermique lors de son fonctionnement, notamment en vue d'absorber efficacement les pics de puissance lors d'une surcharge thermique sans qu'il y ait à sur-dimensionner de manière importante ledit système.

Le but général de l'invention est de répondre en partie à ce besoin.

Un but particulier de l'invention est de proposer un système de refroidissement d'un composant électronique de puissance qui réponde au but général, qui puisse être intégré à l'emballage du composant (« packaging » en anglais), et qui mette en œuvre un dissipateur thermique usuel pour le fonctionnement en régime nominal.

### Exposé de l'invention

Pour ce faire, l'invention a tout d'abord pour objet, un appareil comportant un composant fonctionnel, en particulier un composant électronique, susceptible d'être en surcharge thermique lors de son fonctionnement, et un système de refroidissement du composant, le système de refroidissement comportant :
- un module thermoélectrique, comportant deux faces principales, dont une, dite face froide, et l'autre, dite face chaude, la face froide étant couplée thermiquement avec le composant;
- un premier dissipateur thermique, couplé thermiquement avec la face chaude du module thermoélectrique, le dissipateur comprenant une surface d'échange avec le milieu environnant et en outre au moins une cellule contenant un matériau à changement de phase (MCP), le matériau MCP contenu dans la(les) cellule(s) étant adapté pour fondre lorsque la chaleur dégagée depuis la face froide du module thermoélectrique est celle du composant en surcharge thermique, la surface d'échange étant adaptée pour ramener le matériau MCP de sa phase fondue à sa phase solide lorsque la chaleur dégagée depuis la face froide du module thermoélectrique est celle du composant en fonctionnement qui n'est pas en surcharge thermique.

Autrement dit, selon l'invention, on réalise une partie d'un système de refroidissement qui est uniquement dédiée à l'absorption du surplus de chaleur lors du passage en régime transitoire (surcharge thermique) du composant en fonctionnement.

Lorsque le composant est en surcharge thermique, du fait par exemple qu'il est en surcharge électrique, on met en marche, c'est-à-dire on alimente par un courant électrique, le module thermoélectrique couplé thermiquement avec le composant. Le module thermoélectrique pompe et transfère instantanément le surplus de chaleur au matériau MCP encapsulé dans le premier dissipateur thermique. Ce surplus de chaleur est donc stockée par le matériau MCP ayant changé de phase.

Lors du retour en fonctionnement en régime nominal du composant, la chaleur absorbée par le matériau MCP est déchargée relativement lentement dans le milieu environnant au moyen du premier dissipateur thermique. Ce dernier peut être de dimensions largement réduites par rapport à un deuxième dissipateur thermique, utilisé usuellement pour refroidir le composant en fonctionnement nominal.

Selon un mode de réalisation avantageux, le composant fonctionnel étant un composant électronique, de préférence un composant électronique de puissance à base de silicium (Si), carbure de silicium (SiC) ou nitrure de gallium (GaN). Grâce à l'invention, il est possible d'avoir un système de refroidissement d'un composant électronique de puissance à la fois pendant son fonctionnement nominal et pendant son fonctionnement en surcharge thermique, qui soit de dimensions réduites et intégré au packaging du composant.

Le module thermoélectrique est un module Peltier. Un module Peltier agit réellement comme une pompe à chaleur et permet un transfert immédiat de la chaleur. De préférence, lorsque le composant est un composant électronique de puissance, fonctionnant en surcharge thermique dans une gamme de température 20-200 °C, le matériau thermoélectrique utilisé est de préférence le Tellurure de Bismuth. Il est également envisageable d'utiliser d'autre matériaux tels que des alliages silicium-germanium (SiGe), les Siliciures, les skutterudites, ...

Pour dimensionner le module Peltier de manière optimale, on veille à respecter les règles suivantes. Tout d'abord, il existe un courant optimal au-delà duquel les pertes thermiques P par effet Joule, selon l'équation P = R^{∗}I² où R est la résistance thermique du module et I le courant qui le traverse, sont supérieures à la quantité de chaleur absorbée par effet Peltier dans le module et provoque un réchauffement global du dispositif.

De même, il existe une résistance thermique optimale R du module Peltier permettant de refroidir au mieux le composant en fonctionnement: une résistance thermique trop faible court-circuite thermiquement les faces chaude et froide du module, et à l'inverse une résistance thermique trop grande induit une augmentation de la température du composant en fonctionnement lorsqu'aucun courant ne traverse le module.

Ainsi, de manière optimale, dans le cadre de l'invention, on choisit un fonctionnement du module Peltier à sa résistance thermique optimale et sous un courant électrique en dessous du courant optimal.

De préférence, lorsque le composant est un composant électronique de puissance, la résistance thermique du module thermoélectrique est comprise entre 1 et 10 Kelvin par watt (K/W) pour une puissance de surcharge thermique du composant de 10 W.

Selon un mode de réalisation avantageux, le matériau MCP est de type solide-liquide.

Le matériau MCP préféré, peut être choisi parmi les sels fondus (MgCl₂.6H₂O ou Mg(NO₃).6H.₂O par exemple), les acides gras de préférence l'acide myristique (C₁₄H₂₈O₂), l'acide palmitique (C₁₆H₃₂O₂), l'acide stéarique (C₁₈H₃₆O₂), les cires ou paraffines (CₙH₂ₙ₊₂) et leurs dérivés, les métaux à basse température de fusion à base d'In, de Ga, Bi et Sn, de préférence Bi₆₇In₃₃, SnIn, BiSnPb, GaInSn.

Lorsque le composant est un composant électronique de puissance, le matériau MCP contenu dans la(les) cellule(s) est de préférence adapté pour stocker une quantité de chaleur comprise entre 0,1 à 5kJ.

Selon un mode de réalisation avantageux, le premier dissipateur thermique comporte une pluralité d'ailettes principales, une cellule contenant le matériau MCP étant délimitée par deux ailettes principales consécutives.

De préférence, il est prévu des fibres métalliques ou des nanotubes de carbone noyés dans le matériau MCP.

Selon une variante avantageuse, le premier dissipateur thermique comportant une pluralité d'ailettes secondaires agencées au sein d'une cellule contenant le matériau MCP.

Selon un mode de réalisation avantageux, la face froide du module thermoélectrique étant en interface avec le composant et la face chaude du module thermoélectrique étant en interface avec une face du premier dissipateur thermique.

Les interfaces sont de préférence réalisées par l'application d'un matériau d'interface thermique choisi parmi une colle thermique ou une colle à matrice métallique (Sn) ou, par brasure à l'aide d'un métal d'apport à base d'indium (In) ou d'étain (Sn).

Selon un mode de réalisation avantageux, le composant est supporté par une face d'un substrat, une autre face du substrat étant en interface avec un deuxième dissipateur thermique, du type à ailettes.

Selon un autre mode de réalisation avantageux, le premier et deuxième dissipateurs thermiques sont en outre assemblés mécaniquement entre eux.

L'invention a également pour objet, selon un autre de ses aspects, un procédé de fonctionnement d'un appareil selon l'une des revendications précédentes, comportant les étapes suivantes :
- mise à l'arrêt du module thermoélectrique lors du fonctionnement en régime nominal du composant fonctionnel;
- mise en marche du module thermoélectrique lors du fonctionnement en surcharge thermique du composant fonctionnel.

### Description détaillée

D'autres avantages et caractéristiques de l'invention ressortiront mieux à la lecture de la description détaillée de l'invention faite à titre illustratif et non limitatif en référence aux figures suivantes parmi lesquelles :
- la figure 1 est une vue schématique en perspective d'un appareil comportant un composant électronique et son système de refroidissement selon l'état de l'art;
- la figure 2 est une vue schématique en perspective d'un appareil comportant un composant électronique de puissance et son système de refroidissement selon l'invention ;

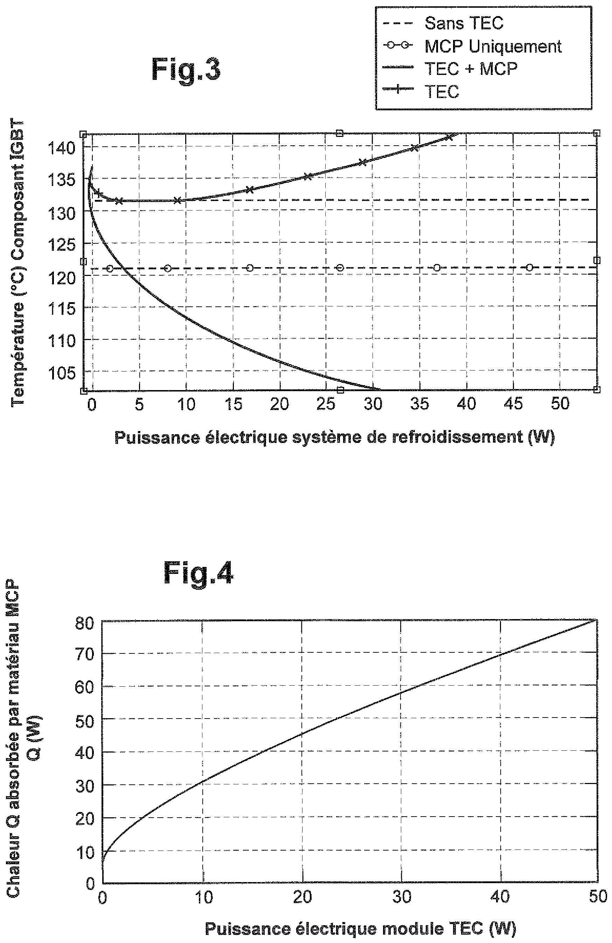

- la figure 3 montre l'évolution de la température des jonctions d'un composants de puissance en fonction de la puissance électrique utilisée par le système de refroidissement qui lui est dédié suivant différentes configurations à savoir respectivement un système selon l'état de l'art avec uniquement un dissipateur thermique sans aucun module thermoélectrique et sans matériau MCP, un système selon l'état de l'art comportant un dissipateur thermique et uniquement un matériau MCP, un système selon l'état de l'art comportant un dissipateur thermique et uniquement un module thermoélectrique, et enfin un système selon l'invention comportant un module Peltier et un dissipateur thermique contenant un matériau MCP couplé thermiquement avec la face chaude dudit module ;
- la figure 4 montre l'évolution de la chaleur absorbée par un matériau MCP en fonction de la puissance électrique d'un module Peltier dans un système de refroidissement d'un composant de puissance selon l'invention ;
- la figure 5 est une vue schématique de côté d'un appareil comportant un composant électronique de puissance et son système de refroidissement selon un exemple de l'invention ;
- la figure 6 est une vue de détail montrant une partie du système de refroidissement d'un composant électronique de puissance selon l'invention ;
- la figure 7 est une vue schématique en perspective d'un appareil comportant un composant électronique de puissance et son système de refroidissement selon l'état de l'art dimensionné pour refroidir le composant en cas de surcharge thermique.

On précise que par souci de clarté les mêmes éléments dans un appareil selon l'état de l'art et un appareil selon l'invention sont désignés par les mêmes références.

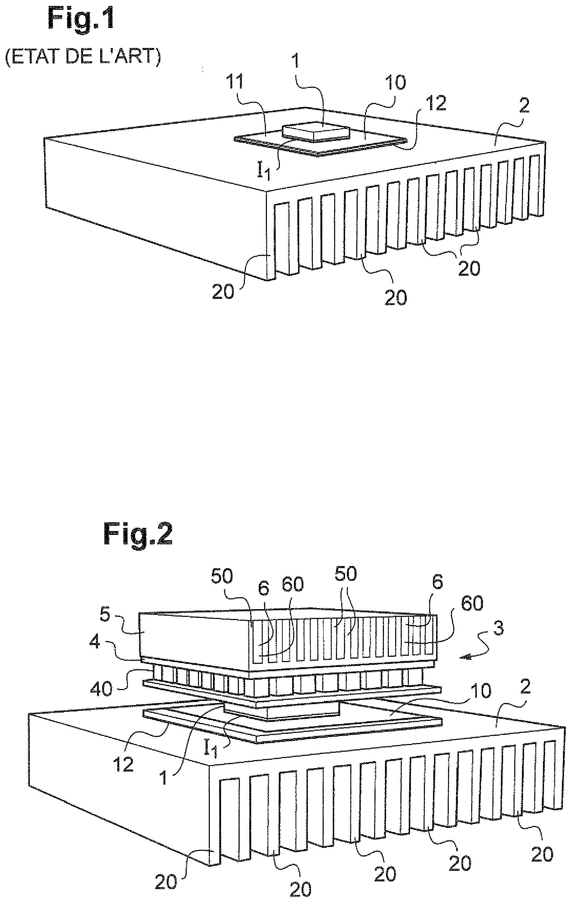

On a représenté en figure 1, un assemblage entre un composant électronique 1 avec son substrat 10 qui le supporte et son système de refroidissement selon l'état de l'art, constitué uniquement par un dissipateur thermique 2 à ailettes verticales 20.

Comme montré, le composant électronique est en interface Il sur l'une des faces principales 11 du substrat 10 et le dissipateur thermique 2 est en interface Il avec l'autre des faces principales 12 du substrat 10. Les interfaces Il peuvent être réalisées à l'aide d'un matériau d'interface thermique de type colle thermique ou colle à matrice métallique, tel que l'étain (Sn) ou au moyen d'une brasure à basse température du type à base d'étain ou d'indium (In).

Le dissipateur thermique 2 à ailettes est dimensionné pour assurer le refroidissement du composant 1 qui est alimenté par un courant nominal donné.

Dans certaines applications telles que celles où l'on réalise un entrainement de moteur, on met en œuvre des circuits électriques utilisant un composant de puissance 1. Un tel composant 1 peut être réalisé dans un matériau à base de Si, SiC ou GaN. Il peut consister en un composant unitaire ou ensemble de composants unitaires. Un tel composant unitaire peut être un transistor bipolaire à grille isolée (IGBT) ou une diode. Un composante de puissance 1 peut donc consister en une association d'un ou plusieurs IGBT avec une ou plusieurs diodes sur un même substrat 10.

Dans ces applications, un composant de puissance 1 peut être soumis à des surcharges électriques car son courant d'alimentation est alors supérieur à celui du courant nominal, typiquement égal à 110 % du courant nominal, et ce pendant des périodes relativement courtes, typiquement de l'ordre de 1 à 5 min. Une surcharge électrique se traduit par une surcharge thermique importante du composant 1, avec en particulier une température de ses jonctions qui peut être nuisible à leur durée de vie.

Aussi, il s'avère nécessaire d'évacuer cette surcharge thermique.

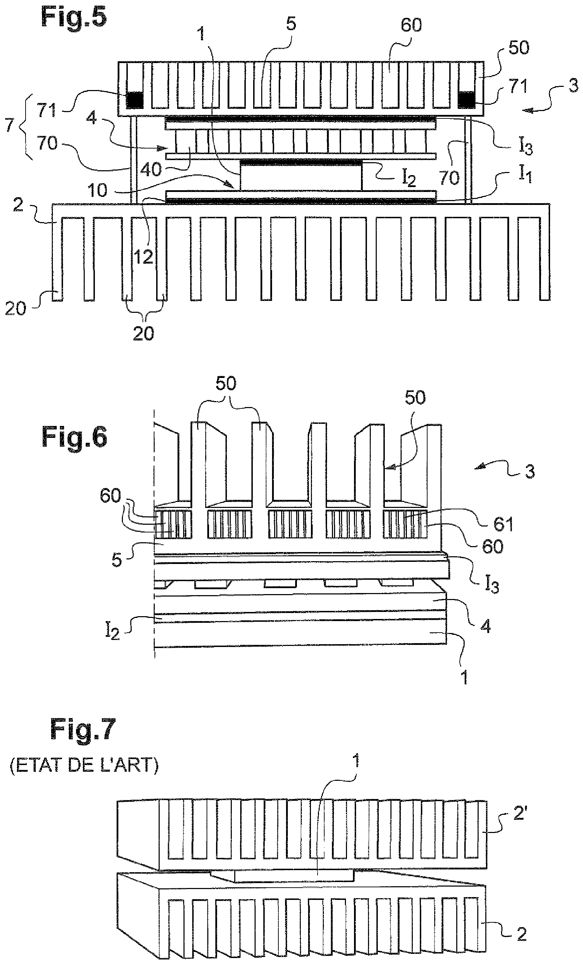

Une solution immédiate pourrait consister à adjoindre au composant 1 un dissipateur thermique à ailettes supplémentaire sur sa face opposée au dissipateur thermique nominal 2 : une telle solution est représentée schématiquement en figure 7 où le dissipateur supplémentaire 2' est identique à celui 2 nominal.

Une telle solution ne peut pas être retenue car comme cela ressort de cette figure 7, le surdimensionnement du système de refroidissement 2, 2' est très conséquent, puisqu'il faut environ le double du volume nécessaire uniquement au refroidissement nominal. Et cela implique qu'on ne peut l'intégrer au packaging du composant 1.

Aussi, les inventeurs ont pensé judicieusement à réaliser une partie 3 de système de refroidissement supplémentaire comme illustré en figure 2.

Le système de refroidissement 3 selon l'invention comporte ainsi tout d'abord un module Peltier 4 dont la face froide 41 est en interface I2 avec le composant 1.

Le module Peltier 4, typiquement en Tellure de Bismuth, est constitué d'une pluralité de paires de jambes thermoélectriques 40 connectées thermiquement en parallèle et électriquement en série.

Le système 3 comporte en outre un dissipateur thermique 5 supplémentaire en interface I3 avec la face chaude 42 du module Peltier 4.

Ce dissipateur 5 supplémentaire comporte une surface d'échange, telle que des ailettes 50 qui permettent l'échange thermique avec le milieu environnant, tel que l'air ou l'eau, et entre deux ailettes 50 consécutives une cellule 6 contenant un matériau 60 à changement de phase (MCP) solide-liquide.

Selon l'invention, on prévoit que :
- le matériau MCP 60 contenu dans les cellules 60 est adapté pour fondre lorsque la chaleur dégagée depuis la face froide 41 du module Peltier 4 est celle du composant 1 en surcharge thermique ;
- la surface d'échange définie par les ailettes 50 est adaptée pour ramener le matériau MCP 60 de sa phase fondue à sa phase solide lorsque la chaleur dégagée depuis la face froide 41 du module Peltier 4 est celle du composant 1 en fonctionnement qui n'est pas en surcharge thermique.

Ainsi, en fonctionnement nominal, seul le dissipateur thermique 2 à ailettes 20 évacue la chaleur du composant de puissance 1. S'il y a eu une surcharge thermique du composant 1 au préalable, alors le matériau MCP 60 fondu revient progressivement à son état solide par évacuation de la chaleur qu'il a stockée par l'intermédiaire des ailettes 50 du dissipateur supplémentaire 5.

En fonctionnement de surcharge thermique, le dissipateur thermique 50 évacue le surplus de chaleur du composant 1 de manière fiable.

Ainsi, selon l'invention, on obtient un système de refroidissement complet 2, 3 qui est dimensionné pour être compatible avec l'intégration de la partie supplémentaire 3, 4, 5 au packaging du composant 1.

Comparativement à une solution avec deux dissipateur thermiques 2, 2' de dimensions comparables selon la figure 7, la solution selon l'invention avec un dissipateur thermique supplémentaire 5 de dimensions largement réduites a comme avantage principale d'avoir un encombrement réduit.

Les inventeurs ont pu quantifier le gain de place entre une solution avec un système de refroidissement 2, 3 selon l'invention et une solution avec un système de refroidissement 2, 2' selon l'état de l'art comme illustré en figure 7.

Les données sont les suivantes :
- composant 1 : puce électronique dont on cherche à limiter la température au maximum à 100°C en régime nominal et à 110°C en régime de surcharge thermique,
- dissipateur thermique 2 : résistance thermique de 1 K/W, volume d'environ 200 cm³ pour évacuer les 70W de puissance et limiter la température de la puce 1 à 100°C.

Les calculs thermiques indiquent :
- dissipateur thermique 2' : résistance thermique de 2 K/W, volume d'environ 100 cm³ pour évacuer une puissance de 50W additionnelle lors d'un pic de puissance et limiter la température du composant 1 à 110°C ;
- système de refroidissement selon l'invention avec dissipateur thermique 5, matériau MCP 60 et module Peltier 4: résistance thermique de l'ordre de 10 K/W, volume d'environ 15 à 20 cm³.

Le matériau MCP 60 pris en compte pour les calculs est la paraffine dont la température de fusion est égale à 110°C, la chaleur latente de fusion égale à 180 kJ/kg et la densité égale à 0.8 g/cm³.

Le module Peltier 4 pris en compte pour les calculs est constitué de 324 jambes thermoélectriques en Tellure de Bismuth Bi2Te3, de dimensions unitaires égales à 1 mm^{2 ∗} 0.54 mm de part et d'autre part réalisé sur un substrat en AlN ou Al2O3 et, dont la résistance thermique est égale à 1 K/W.

L'invention présente un avantage certain si la durée du pic de puissance n'est pas trop longue, globalement inférieure à 10 min car au-delà le matériau MCP 60 sélectionné nécessite un trop grand volume d'expansion pour stocker la puissance requise.

On constate qu'avec les données indiquées, le gain en volume pour la partie 3 supplémentaire du système de refroidissement selon l'invention qui permet d'évacuer le pic de chaleur est de l'ordre de 50 à 60 % comparativement à un dissipateur thermique à ailettes usuel 2' qui serait ajouté comme selon la figure 7.

Au préalable, les inventeurs ont également pensé à d'autres solutions selon l'état de l'art pour évacuer le surplus de chaleur du composant de puissance 1.

Ils ont ainsi calculé par simulation l'évolution de la température des jonctions d'un composants de puissance 1 en fonction de la puissance électrique utilisée par un système de refroidissement qui lui est dédié suivant différentes configurations à savoir respectivement un système selon l'état de l'art avec uniquement un dissipateur thermique sans aucun module thermoélectrique et sans matériau MCP, un système selon l'état de l'art comportant un dissipateur thermique et uniquement un matériau MCP, un système selon l'état de l'art comportant un dissipateur thermique et uniquement un module thermoélectrique, et en fin un système 3 selon l'invention comportant un module Peltier 4 et un dissipateur thermique 5 contenant un matériau MCP 60 couplé thermiquement avec la face chaude 42 dudit module. Ces différentes évolutions sont représentées en figure 3.

La figure 4 montre quant à elle l'évolution de la chaleur absorbée par un matériau MCP en fonction de la puissance électrique d'un module Peltier dans un système de refroidissement d'un composant de puissance selon l'invention.

Il ressort clairement des figures 3 et 4 que la combinaison d'un module Peltier 4 et d'un matériau 60 MCP permet un meilleur refroidissement des composants de puissance 1 en comparaison avec un seul dissipateur thermique 2' supplémentaire. A titre indicatif, un système de refroidissement selon l'invention permet de réduire la température de composants de puissance 1 tels que des IGBT, de plus de 20 °C en comparaison avec un système de refroidissement avec uniquement un dissipateur supplémentaire 2'.

On a représenté en détail en figure 5, un assemblage entre les différents composants d'un appareil intégrant un composant électronique de puissance 1 et un système de refroidissement complet, i.e. le dissipateur thermique dédié au refroidissement en régime nominal et le système de refroidissement selon l'invention 3 dédié au refroidissement en surcharge thermique.

Pour réaliser cet assemblage de manière fiable, il faut veiller de façon judicieuse à éviter la refusion de la soudure des composants de puissance 1 ou de jambes thermoélectriques 40 du module Peltier 4 lors de l'assemblage.

Classiquement, les jambes thermoélectriques 40 sont assemblées au sein d'un module Peltier 4 à l'aide de soudures SnAgCu ou SnPb ayant des températures de fusion de l'ordre de 200°C. Les interfaces Il entre composants de puissance 1 et substrat 10 et entre substrat 10 et dissipateur thermique 2 sont réalisées classiquement à l'aide de mélange d'alliages CuSn (Température de fusion Tf= 250-350°C) par brasage en phase liquide transitoire (TLPS), ou d'alliages SnAgCu (Tf = 217°C) ou des particules d'Ag frittées (T de réalisation de l'ordre de 250 °C mais Tf > 600°C).

La technologie d'assemblage du système de refroidissement 3 selon l'invention ne doit donc pas mettre en œuvre des températures de procédé supérieures aux températures des soudures mises enjeu lors de l'assemblage.

Ainsi, l'interface I2 entre le composant de puissance 1 et le module 4 et l'interface I3 reliant le module 4 au dissipateur 5 contenant le MCP 60 sont avantageusement réalisées en utilisant un matériau d'interface thermique qui est une colle thermique ou une colle à matrice métallique à base d'étain ou une brasure basse température à base d'indium ou d'étain. Il va de soi que l'on veille à respecter le fait que la température du procédé mis en œuvre dans l'interface I2 est inférieure à la température de fusion de la brasure utilisée pour assembler les jambes thermoélectriques 40.

Par ailleurs, sur cette figure 5, on a représenté une variante avantageuse d'assemblage qui permet de le rigidifier et garantir une plus grande robustesse. Ainsi, il peut être prévu un dispositif de fixation supplémentaire 7 entre les deux dissipateurs thermiques 2 et 5. Ce dispositif 7 peut consister en des tirants 70 fixés sur l'un des dissipateurs, tel que celui représenté en 2 sur la figure 5, qui sont vissés à l'aide d'écrous 71 à l'autre des dissipateurs, tel que celui représenté en 5 sur la figure5.

On a représenté en figure 6, une variante avantageuse qui permet d'améliorer les échanges thermiques entre les cellules 6 contenant le matériau MCP 60 et le dissipateur thermique 5 qui les intègre. Selon cette variante, il est prévu une pluralité d'ailettes secondaires 51 agencées au sein de chaque cellule 6. On augmente ainsi la surface d'échange entre le matériau MCP en fusion et les ailettes de refroidissement 50 et donc on permet un retour à l'état solide du matériau MCP plus rapide. Autrement dit, on augmente ainsi la réactivité thermique du système de refroidissement selon l'invention.

D'autres variantes et améliorations peuvent être prévues sans pour autant sortir du cadre de l'invention.

Ainsi, on peut envisager en lieu et place d'ailettes principales 50 pour définir la surface d'échange adaptée du dissipateur thermique 5 avec le milieu environnant, on peut envisager des serpentins.

Par ailleurs, on peut envisager d'intégrer des nanotubes de carbones ou des fils métalliques au sein du matériau MCP pour améliorer sa conductivité thermique globale, et ainsi obtenir une meilleure percolation de la chaleur.

L'invention n'est pas limitée aux exemples qui viennent d'être décrits ; on peut notamment combiner entre elles des caractéristiques des exemples illustrés au sein de variantes non illustrées.

## Revendications

1. Appareil comportant un composant fonctionnel (1) susceptible d'être en surcharge thermique lors de son fonctionnement, et un système de refroidissement (2, 3) du composant, le système de refroidissement (3) comportant :
- un module thermoélectrique (4), comportant deux faces principales, dont une, dite face froide (41), et l'autre, dite face chaude (42), la face froide étant couplée thermiquement avec le composant;
- un premier dissipateur thermique (5), couplé thermiquement avec la face chaude (42) du module thermoélectrique, le dissipateur comprenant une surface d'échange (50) avec le milieu environnant et en outre au moins une cellule (6) contenant un matériau (60) à changement de phase (MCP), le matériau MCP contenu dans la(les) cellule(s) étant adapté pour fondre lorsque la chaleur dégagée depuis la face froide du module thermoélectrique est celle du composant en surcharge thermique, la surface d'échange étant adaptée pour ramener le matériau MCP de sa phase fondue à sa phase solide lorsque la chaleur dégagée depuis la face froide du module thermoélectrique est celle du composant en fonctionnement qui n'est pas en surcharge thermique.

2. Appareil selon la revendication 1, le composant fonctionnel étant un composant électronique.

3. Appareil selon la revendication 2, le composant électronique étant un composant électronique de puissance à base de silicium (Si), carbure de silicium (SiC) ou nitrure de gallium (GaN).

4. Appareil selon l'une des revendications précédentes, le module thermoélectrique étant un module Peltier.

5. Appareil selon l'une des revendications précédentes, la résistance thermique du module thermoélectrique étant comprise entre 1 et 10 Kelvin par watt (K/W) pour une puissance de surcharge thermique du composant de 10 W.

6. Appareil selon la revendication 3, le matériau MCP contenu dans la(les) cellule(s) étant adapté pour stocker une quantité de chaleur comprise entre 0,1 à 5kJ.

7. Appareil selon la revendication 6, le matériau MCP étant choisi parmi les sels fondus (MgCl₂.6H₂O ou Mg(NO₃).6H₂O par exemple), les acides gras, de préférence l'acide myristique (C₁₄H₂₈O₂), l'acide palmitique (C₁₆H₃₂O₂) ou l'acide stéarique (C₁₈H₃₆O₂), les cires ou paraffines (CₙH₂ₙ₊₂) et leurs dérivés, les métaux à basse température de fusion à base d'In, de Ga, Bi et Sn, de préférence Bi₆₇In₃₃, SnIn, BiSnPb, GaInSn.

8. Appareil selon l'une des revendications précédentes, le premier dissipateur thermique (5) comportant une pluralité d'ailettes principales (50), une cellule (6) contenant le matériau MCP étant délimitée par deux ailettes principales consécutives (50).

9. Appareil selon l'une des revendications précédentes, comportant des fibres métalliques ou des nanotubes de carbone noyés dans le matériau MCP.

10. Appareil selon la revendication 8 ou 9, le premier dissipateur thermique (5) comportant une pluralité d'ailettes secondaires (51) agencées au sein d'une cellule (6) contenant le matériau MCP (60).

11. Appareil selon l'une des revendications précédentes, la face froide (41) du module thermoélectrique (4) étant en interface (I2) avec le composant (1) et la face chaude (42) du module thermoélectrique (4) étant en interface (I3) avec une face du premier dissipateur thermique (5).

12. Appareil selon la revendication 11, les interfaces (I2, I3) étant réalisées par l'application d'un matériau d'interface thermique choisi parmi une colle thermique ou une colle à matrice métallique (Sn) ou, par brasure à l'aide d'un métal d'apport à base d'indium (In) ou d'étain (Sn).

13. Appareil selon l'une des revendications précédentes, le composant étant supporté par une face (11) d'un substrat (10), une autre face (12) du substrat étant en interface avec un deuxième dissipateur thermique (2), du type à ailettes.

14. Appareil selon la revendication 13, le premier et deuxième dissipateurs thermiques étant en outre assemblés mécaniquement entre eux.

15. Procédé de fonctionnement d'un appareil selon l'une des revendications précédentes, comportant les étapes suivantes :
- mise à l'arrêt du module thermoélectrique (4) lors du fonctionnement en régime nominal du composant fonctionnel (1);mise en marche du module thermoélectrique (4) lors du fonctionnement en surcharge thermique du composant fonctionnel (4).

## Patentansprüche

1. Vorrichtung, welche eine funktionale Komponente (1), die während ihres Betriebs einer thermischen Überlastung ausgesetzt sein kann, und ein System zur Kühlung (2, 3) der Komponente aufweist, wobei das Kühlsystem (3) aufweist:
- ein thermoelektrisches Modul (4), das zwei Hauptseiten aufweist, von denen eine die sogenannte kalte Seite (41) und die andere die sogenannte warme Seite (42) ist, wobei die kalte Seite mit der Komponente thermisch gekoppelt ist;
- einen ersten Kühlkörper (5), der mit der warmen Seite (42) des thermoelektrischen Moduls thermisch gekoppelt ist, wobei der Kühlkörper eine Fläche zum Austausch (50) mit dem umgebenden Medium und außerdem wenigstens eine Zelle (6), die ein Phasenwechselmaterial (MCP) (60) enthält, umfasst, wobei das in der (den) Zelle (n) enthaltene Material MCP dazu eingerichtet ist zu schmelzen, wenn die von der kalten Seite des thermoelektrischen Moduls freigesetzte Wärme diejenige der einer thermischen Überlastung ausgesetzten Komponente ist, wobei die Austauschfläche dazu eingerichtet ist, das Material MCP aus seinen geschmolzenen Phase wieder in seine feste Phase umzuwandeln, wenn die von der kalten Seite des thermoelektrischen Moduls freigesetzte Wärme diejenige der in Betrieb befindlichen Komponente ist, welche nicht einer thermischen Überlastung ausgesetzt ist.

2. Vorrichtung nach Anspruch 1, wobei die funktionale Komponente eine elektronische Komponente ist.

3. Vorrichtung nach Anspruch 2, wobei die elektronische Komponente eine leistungselektronische Komponente auf der Basis von Silicium (Si), Siliciumcarbid (SiC) oder Galliumnitrid (GaN) ist.

4. Vorrichtung nach einem der vorhergehenden Ansprüche, wobei das thermoelektrische Modul ein Peltier-Modul ist.

5. Vorrichtung nach einem der vorhergehenden Ansprüche, wobei der thermische Widerstand des thermoelektrischen Moduls zwischen 1 und 10 Kelvin pro Watt (K/W) für eine thermische Überlastleistung der Komponente von 10 W liegt.

6. Vorrichtung nach Anspruch 3, wobei das in der (den) Zelle(n) enthaltene Material MCP dazu eingerichtet ist, eine Wärmemenge zwischen 0,1 und 5 kJ zu speichern.

7. Vorrichtung nach Anspruch 6, wobei das Material MCP aus den geschmolzenen Salzen (zum Beispiel MgCl₂.6H₂O oder Mg(NO₃).6H₂O), den Fettsäuren, vorzugsweise Myristinsäure (C₁₄H₂₈O₂), Palmitinsäure (C₁₆H₃₂O₂) oder Stearinsäure (C₁₈H₃₆O₂), den Wachsen oder Paraffinen (CₙH₂ₙ₊₂) und ihren Derivaten, den Metallen mit niedriger Schmelztemperatur auf der Basis von In, von Ga, Bi und Sn, vorzugsweise Bi₆₇In₃₃, SnIn, BiSnPb, GaInSn, ausgewählt ist.

8. Vorrichtung nach einem der vorhergehenden Ansprüche, wobei der erste Kühlkörper (5) mehrere Hauptrippen (50) aufweist, wobei eine das Material MCP enthaltende Zelle (6) von zwei aufeinander folgenden Hauptrippen (50) begrenzt wird.

9. Vorrichtung nach einem der vorhergehenden Ansprüche, welche Metallfasern oder Kohlenstoffnanoröhren aufweist, die in das Material MCP eingebettet sind.

10. Vorrichtung nach Anspruch 8 oder 9, wobei der erste Kühlkörper (5) mehrere sekundäre Rippen (51) aufweist, die innerhalb einer das Material MCP (60) enthaltende Zelle (6) angeordnet sind.

11. Vorrichtung nach einem der vorhergehenden Ansprüche, wobei die kalte Seite (41) des thermoelektrischen Moduls (4) eine Grenzfläche (I2) mit der Komponente (1) ist und die warme Seite (42) des thermoelektrischen Moduls (4) eine Grenzfläche (13) mit einer Seite des ersten Kühlkörpers (5) ist.

12. Vorrichtung nach Anspruch 11, wobei die Grenzflächen (I2, I3) durch Aufbringung eines thermischen Grenzflächenmaterials, das aus einem Heißleim oder einem Klebstoff mit metallischer Matrix (Sn) ausgewählt ist, oder durch Hartlöten mithilfe eines Zusatzmetalls auf der Basis von Indium (In) oder von Zinn (Sn) hergestellt sind.

13. Vorrichtung nach einem der vorhergehenden Ansprüche, wobei die Komponente von einer Seite (11) eines Substrats (10) getragen wird, wobei sich eine andere Seite (12) des Substrats an einer Grenzfläche mit einem zweiten Kühlkörper (2) vom Rippentyp befindet.

14. Vorrichtung nach Anspruch 13, wobei der erste und der zweite Kühlkörper außerdem mechanisch miteinander verbunden sind.

15. Verfahren zum Betrieb einer Vorrichtung nach einem der vorhergehenden Ansprüche, welches die folgenden Schritte umfasst:
- Abschaltung des thermoelektrischen Moduls (4) während des Betriebs der funktionalen Komponente (1) im Nennbetrieb; Inbetriebsetzung des thermoelektrischen Moduls (4) während des Betriebs der funktionalen Komponente (4) mit thermischer Überlastung.

## Claims

1. A device comprising a functional component (1) liable to be thermally overloaded during the operation thereof, and a system for cooling (2, 3) the component, the cooling system (3) comprising:
- a thermoelectric module (4), comprising two main faces, one called the cold face (41), and the other called the hot face (42), the cold face being thermally coupled to the component;
- a first heat sink (5), thermally coupled to the hot face (42) of the thermoelectric module, the heat sink comprising an exchange surface (50) with the surrounding environment and furthermore at least one cell (6) containing a phase-change material (PCM) (60), the PCM material contained in the cell(s) being adapted so as to melt when the heat released from the cold face of the thermoelectric module is that of the component under thermal overload, the exchange surface being adapted so as to return the PCM material from the molten phase thereof to the solid phase thereof when the heat released from the cold face of the thermoelectric module is that of the component in operation which is not under thermal overload.

2. The device as claimed in claim 1, the functional component being an electronic component.

3. The device as claimed in claim 2, the electronic component being a power electronic component based on silicon (Si), silicon carbide (SiC) or gallium nitride (GaN).

4. The device as claimed in one of the preceding claims, the thermoelectric module being a Peltier module.

5. The device as claimed in one of the preceding claims, the thermal resistance of the thermoelectric module being between 1 and 10 kelvin per watt (K/W) for a power of thermal overload of the component of 10 W.

6. The device as claimed in claim 3, the PCM material contained in the cell(s) being adapted so as to store a quantity of heat of between 0.1 to 5 kJ.

7. The device as claimed in claim 6, the PCM material being chosen from molten salts (MgCl₂.6H₂O or Mg(NO₃).6H₂O for example); fatty acids, preferably myristic acid (C₁₄H₂₈O₂), palmitic acid (C₁₆H₃₂O₂) or stearic acid (C₁₈H₃₆O₂); waxes or paraffins (CₙH₂ₙ₊₂) and their derivatives; metals with low melting points based on In, Ga, Bi and Sn, preferably Bi₆₇In₃₃, SnIn, BiSnPb, GaInSn.

8. The device as claimed in one of the preceding claims, the first heat sink (5) comprising a plurality of main fins (50), a cell (6) containing the PCM material being delimited by two consecutive main fins (50).

9. The device as claimed in one of the preceding claims, comprising metal fibres or carbon nanotubes that are embedded in the PCM material.

10. The device as claimed in claims 8 or 9, the first heat sink (5) comprising a plurality of secondary fins (51) arranged within a cell (6) containing the PCM material (60).

11. The device as claimed in one of the preceding claims, the cold face (41) of the thermoelectric module (4) having an interface (12) with the component (1) and the hot face (42) of the thermoelectric module (4) having an interface (13) with a face of the first heat sink (5).

12. The device as claimed in claim 11, the interfaces (12, 13) being produced by applying a thermal interface material chosen from a thermal adhesive or having a metal matrix (Sn) adhesive solder, or by soldering using a solder based on indium (In) or tin (Sn).

13. The device as claimed in one of the preceding claims, the component being borne by a face (11) of a substrate (10), another face (12) of the substrate interfacing with a second heat sink (2), of the finned type.

14. The device as claimed in claim 13, the first and second heat sinks furthermore being mechanically assembled together.

15. A method for operating a device as claimed in one of the preceding claims, comprising the following steps:
- turning off the thermoelectric module (4) when the functional component (1) is operating in the nominal regime; and turning on the thermoelectric module (4) when the functional component (4) is operating under thermal overload.
